# EUROPEAN PATENT SPECIFICATION

(11) **EP 2 461 027 B1**
(45) Date of publication and mention of the grant of the patent: **31.07.2013**
(21) Application number: 10193666.4
(22) Date of filing: 03.12.2010
(51) Int. Cl.: F03D 9/00, G01R 27/16, H02J 3/24, H02P 9/00, G01R 31/34

(54) **Arrangement and method for testing an electric power generation system**
Anordnung und Verfahren zum Prüfen eines Stromerzeugungssystems
Agencement et procédé de test d'un système de génération d'alimentation électrique

(43) Date of publication of application: 06.06.2012
(73) Proprietor: Siemens Aktiengesellschaft, 80333 München (DE)
(72) Inventor: Dreyer, Thomas, 28832 Achim (DE); Wulff, Steffen, 28217 Bremen (DE)

(56) References cited:
- EP-A2- 1 796 259
- WO-A1-03/058789
- IOV F ET AL: "Grid Code Compliance of Grid-Side Converter in Wind Turbine Systems", POWER ELECTRONICS SPECIALISTS CONFERENCE, 2006. PESC '06. 37TH IEEE JEJU, KOREA 18-22 JUNE 2006, PISCATAWAY, NJ, USA,IEEE, 18 June 2006 (2006-06-18), pages 1-7, XP010945038, DOI: DOI:10.1109/PESC.2006.1711744 ISBN: 978-0-7803-9716-3
- SHUITAO YANG ET AL: "A robust control scheme for grid-connected voltage source inverters", APPLIED POWER ELECTRONICS CONFERENCE AND EXPOSITION (APEC), 2010 TWENTY-FIFTH ANNUAL IEEE, IEEE, PISCATAWAY, NJ, USA, 21 February 2010 (2010-02-21), pages 1002-1009, XP031649580, ISBN: 978-1-4244-4782-4

## Description

### Field of invention

The present invention relates to an arrangement and to a method for testing an electric power generation system, in particular a wind turbine system, connected to an utility grid operating at a grid voltage. In particular, the present invention relates to an arrangement and to a method for testing an electric power generation system, wherein a response of the electric power generation system to a voltage drop is examined.

### Art Background

An electric utility grid may on one hand be connected to one or more electric power generation systems which feed electric energy in the form of current and/or voltage power signals into the utility grid. On the other hand, the utility grid may be connected to one or more consumers or loads which receive electric energy from the utility grid.

During operation of the electric power generation system(s) a failure in the electrical properties of the electrical utility grid may occur, such as a low voltage dip caused for example by a (partial) short-cut. The electric power generation system(s), in particular a wind turbine system, has to be adapted to withstand such a low voltage dip without being comprised or damaged and without causing subsequent problems at the utility grid. Thereby, a requirement arises to test the electrical behavior of the electric power generation system, in particular the wind turbine system, in the case of a low voltage dip or low voltage drop at a connection point between the electric power generation system and the utility grid.

Document WO 03/058789 Al discloses a power grid connection system for a wind turbine generator, wherein a wind turbine driven rotor and a stator connected to supply electrical power to the power grid are comprised in the wind power grid connection system, wherein the wind turbine generator is kept connected to the power grid during a power grid fault to take active part in the stabilization of the power grid.

However, it has been observed that conventional arrangements for testing the behavior of an electric power generation system may not be suitable in all situations and may not be suitable for advanced test procedures.

There may be a need for an arrangement and for a method for testing an electric power generation system, in particular a wind turbine system, wherein the method or arrangement is adapted to perform an improved test procedure for examining the electric power generation system in the case of a low voltage dip or voltage drop at a terminal connecting the electric power generation system and the utility grid.

### Summary of the Invention

This need may be met by the subject matter according to the independent claims. Advantageous embodiments of the present invention are described by the dependent claims.

According to an embodiment an arrangement (in particular comprising one or more electronic or electric components, such as one or more impedances, coils and/or switches) for testing (in particular examining, analyzing, evaluating) an electric power generation system (adapted for generating electric energy in form of power current and/or voltage signals), in particular a wind turbine system (in particular comprising a wind turbine tower, a nacelle mounted at the top of the wind turbine tower, a rotation shaft rotatably supported within the nacelle and having affixed thereto one or more rotor blades, and a generator mechanically connected to the rotation shaft for generating electric current and/or voltage signals upon rotation of the rotation shaft), connected to an utility grid (which is provided with electric energy from the electric power generation system and supplies electric energy to one or more consumers or loads) operating at a grid voltage (such as a predetermined voltage between for example 10 kV and 50 kV and having also a predetermined frequency, such as 50 Hz or 60 Hz), wherein the arrangement comprises an input terminal (or a number of input terminals, the number corresponding to the number of different electrical phases) for connecting the arrangement to an output terminal (or in particular a number of output terminals, each output terminal corresponding to a particular electrical phase) of the power generation system; a grid terminal (or a number of grid terminals corresponding to the number of different electric phases) for connecting the arrangement to the utility grid; a series coil (or an impedance or an inductor being serially connected) connected between the input terminal and the grid terminal (the series coil having an impedance which may be represented by at least an imaginary part, wherein the impedance defines a resistance of the series coil, wherein the resistance in particular linearly increases with increasing frequency of the power signal flowing through the series coil); a reference node for connecting to a reference electric potential, in particular a ground potential or earth potential; and a shunt coil system (or short-cut coil system, in particular comprising at least one coil or impedance or inductor, in particular comprising two coils or two inductors or two impedances) having a variable impedance (such that the impedance of the shunt coil system may be varied as desired within a certain range of impedances or such that the shunt coil system may adopt at least two different impedances), wherein the shunt coil system is connected between the input terminal and the reference node (wherein in particular the shunt coil system may comprise two coils or inductors and the two coils or inductors may be connected to the reference node via at least one switch) and wherein the variable impedance is adjustable such that a voltage at the input terminal selectively amounts to a predetermined first voltage or to a predetermined second voltage different from the first voltage (such that the voltage at the input terminal may be intentionally be adjusted to amount to the predetermined first voltage or may intentionally be adjusted to amount to the predetermined second voltage, wherein thus both, the first voltage and the second voltage are achievable at the input terminal), wherein the first voltage and the second voltage are both lower than the grid voltage.

Thereby, a voltage drop at the input terminal compared to the grid voltage may be achieved using the test arrangement. In particular, two voltage drops having two different magnitudes in voltage may be achieved at the input terminal, in order to more thoroughly and more accurately examine the electrical behavior of the electric power generation system upon the application of the different voltage drops. Thereby, the electric power generation system, in particular the wind turbine system, may be more thoroughly analyzed and/or evaluated to determine whether the electric power generation system meets local requirements or regulations. In particular, the behavior of the electric power generation system upon application of a variable voltage drop may be examined, in particular regarding the behavior of recovery from the voltage drops having different magnitudes. In particular, by generating the first voltage or selectively the second voltage at the input terminal a failure in the electrical utility grid with a mi-soperation of a grid protection unit may be simulated using the arrangement according to an embodiment.

In particular, firstly the first voltage may be applied to the input terminal and the first voltage may be maintained or hold for a certain time period and after that the second voltage may be applied and maintained or kept or hold for a further time interval, during which the electrical response of the electric power generation system may be determined, in particular using a current and/or voltage measurement system.

The test arrangement may be considered as a low voltage ride through test unit, which may produce a large voltage drop or large voltage dip followed by a smaller voltage dip representing an interstage voltage between the large voltage dip and the nominal voltage of the utility grid. In particular, a parallel switch with an adjusted coil may produce a variable interstage before the voltage dip is going back to the nominal voltage.

According to an embodiment the shunt coil system is adapted to adopt (or to assume) a first impedance, resulting in the first voltage at the input terminal being between 0% and 20%, in particular between 0% and 10%, of the grid voltage. Thereby, the large voltage drop may be achieved by adjusting the first impedance appropriately, such as determined by simulating the electrical properties of the test arrangement. Thereby, the electric power generation system may be subjected to a voltage drop to which it is supposed to react in a certain manner regarding its electrical behavior. If the electric power generation system exhibits a response satisfying predetermined criteria the electric power generation system may pass the test and may then continuously be connected to the utility grid for supplying electric energy into the utility grid in a production operation.

According to an embodiment the shunt coil system is adapted to adopt a second impedance (being different from the first impedance, in particular being larger in magnitude than the first impedance), resulting in the second voltage at the input terminal being between 50% and 95%, in particular between 80% and 90%, of the grid voltage. Thereby, a lower voltage drop may be achieved, to also consider or examine the electrical behavior of the electric power generation system when subjected to a low voltage drop. In reality or in a real utility grid such a low voltage drop may frequently occur, in particular even more frequently than a larger voltage drop.

According to an embodiment the first impedance is adopted during a first time interval which amounts in particular to between 0.1 s and 2 s, further in particular to between 0.5 s and 1 s. In particular, the electric power generation system may be required to withstand the large power drop leading to the first voltage at the input terminal during a first time interval which may be set according to local regulations or according to the particular application.

According to an embodiment the second impedance is adopted during a second time interval different from the first time interval, wherein the second time interval amounts in particular to between 0.5 s and 10 s, further in particular to between 1 s and 5 s. In particular, the second time interval may be larger than the first time interval.

In particular, the first time interval and also the second time interval may be set or controlled by a control system which may be adapted to perform adjusting the impedance of the shunt coil system, which may in particular be adapted to perform one or more switchings of switches in order to connect one or more coils between the input terminal and the reference node causing voltage drops of different sizes.

According to an embodiment the shunt coil system comprises a first coil and a second coil that are connectable (in particular connected via at least one switch) in series between the input terminal and the reference node. In alternative embodiments the first coil and the second coil may be connectable in parallel between the input terminal and the reference node. In particular, by connecting either exclusively the first coil, or exclusively the second coil or both the first coil and the second coil between the input terminal and the reference node different voltage drops may be achieved, such that selectively the first voltage or the second voltage is applied at the input terminal.

According to an embodiment the first impedance is adopted, if exclusively the first coil but not the second coil is connected between the input terminal and the reference point and the second impedance is adopted, if the first coil and the second coil are connected in series between the input terminal and the reference point. Thereby, changing the impedance of the shunt coil system may be simplified.

According to an embodiment the shunt coil system further comprises a first switch, in particular two first switches, connected in series with the first coil. In particular, the two first switches may be connected in series with the first coil between the input terminal and the reference node. By providing two first switches a switching time may be reduced for establishing the first voltage and/or the second voltage at the input terminal at the predetermined first time interval or the predetermined second time interval, respectively. Thereby, adjusting the impedance, in particular a time interval during which a particular voltage is applied, may be simplified.

According to an embodiment the shunt coil system comprises a second switch connected in series with the second coil. In particular, the second coil and the second switch may be connected in series between the input terminal and the first coil which in turn is connected to the reference node such that by closing the second switch a current flow may occur via the second coil and the first coil towards the reference node to achieve the low voltage drop, in order to generate the second voltage at the input terminal.

According to an embodiment the test arrangement further comprises a measurement system adapted for measuring a current flow at the input terminal, at a point between the shunt coil system and the reference node and/or at the grid terminal. By using the measurement system a behavior or a response of the electric power generation system upon subjecting the electric power generation system to the differently sized voltage drops may be measured, evaluated and examined.

According to an embodiment the measurement system is further adapted for measuring a voltage between a fixed potential node and the input terminal and/or a point between the shunt coil system and the reference node and/or the grid terminal. In particular, a potential at the input terminal, at the point between the shunt coil system and the reference node and/or at the grid terminal relative to the fixed potential node may be measured using the measurement system.

In particular, the measurement system may be adapted to store measurement data regarding current and/or voltage measurements and may also be adapted for evaluating the measurement data, in order to determine, whether the electric power generation system exhibits a response to the differently sized voltage drops satisfying predetermined criteria.

According to an embodiment the test arrangement further comprises a control system (in particular comprising signal lines to components of the shunt coil system, a processing system which is in particular programmable, one or more relays connected to one or more switches of the shunt coil system) for controlling (in particular switching, regulating and/or adjusting) the shunt coil system such that a voltage at the input terminal follows a predetermined voltage time course (a predetermined relationship of the voltage with respect to time) comprising the first voltage succeeded by the second voltage.

In particular, the first voltage may immediately be succeeded by the second voltage. Thus, first a large voltage drop may be generated in such a way that the first voltage is applied to the input terminal and immediately thereafter a lower voltage drop may be generated such that the second voltage is applied at the input terminal. In other embodiments another voltage different from the first voltage and different also from the second voltage may be applied at the input terminal between applying the first voltage at the input terminal and applying the second voltage at the input terminal. Further, after applying the second voltage at the input terminal the nominal voltage, i.e. the grid voltage may be applied at the input terminal, in particular by disconnecting the first coil and the second coil from the input terminal, thus preventing current flow through the first coil and/or the second coil from the input terminal towards the reference node.

It should be noted that features (individually or in any combination) disclosed, described, explained, mentioned or provided with reference to an embodiment of an arrangement for testing an electric power generation system may also be applied (individually or in any combination) to a method for testing an electric power generation system according to an embodiment and vice versa.

According to an embodiment a method for testing an electric power generation system, in particular a wind turbine system, connected to a utility grid operating at a grid voltage is provided, wherein the method comprises connecting the arrangement, via an input terminal, to an output terminal of the power generation system; connecting the arrangement, via a grid terminal, to the utility grid, wherein a series coil is connected between the input terminal and the grid terminal; and varying an impedance of a shunt coil system connected between the input terminal and a reference node such that a voltage at the input terminal selectively amounts to a predetermined first voltage or to a predetermined second voltage different form the first voltage, wherein the first voltage and the second voltage are both lower than the grid voltage.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

Embodiments of the present invention are now described with reference to the accompanying drawings to which the invention is not limited.
Fig. 1 schematically illustrates an arrangement for testing an electric power generation system according to an embodiment;
Fig. 2 schematically illustrates an arrangement for testing an electric power generation system according to another embodiment; and
Fig. 3 schematically illustrates a diagram of a voltage course of a voltage generated by the arrangement for testing an electric power generation system illustrated in Fig. 1 or Fig. 2 according to an embodiment, wherein the electric power generation system is subjected to the illustrated voltage.

### Detailed Description

The illustration in the drawing is schematical. It is noted that in different figures, similar or identical elements are provided with the same reference signs or with reference signs, which are different from the corresponding reference signs only within the first digit.

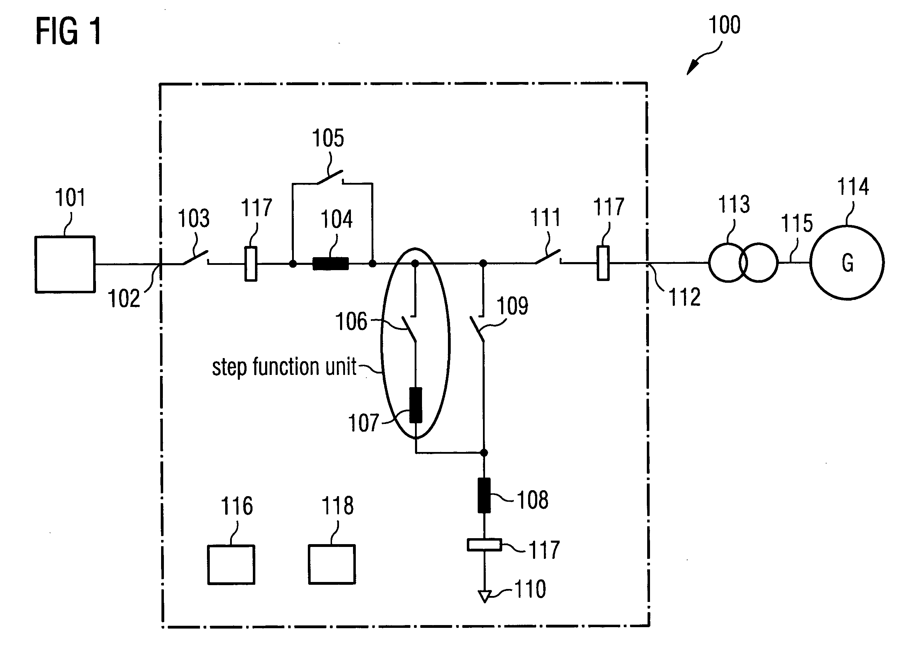

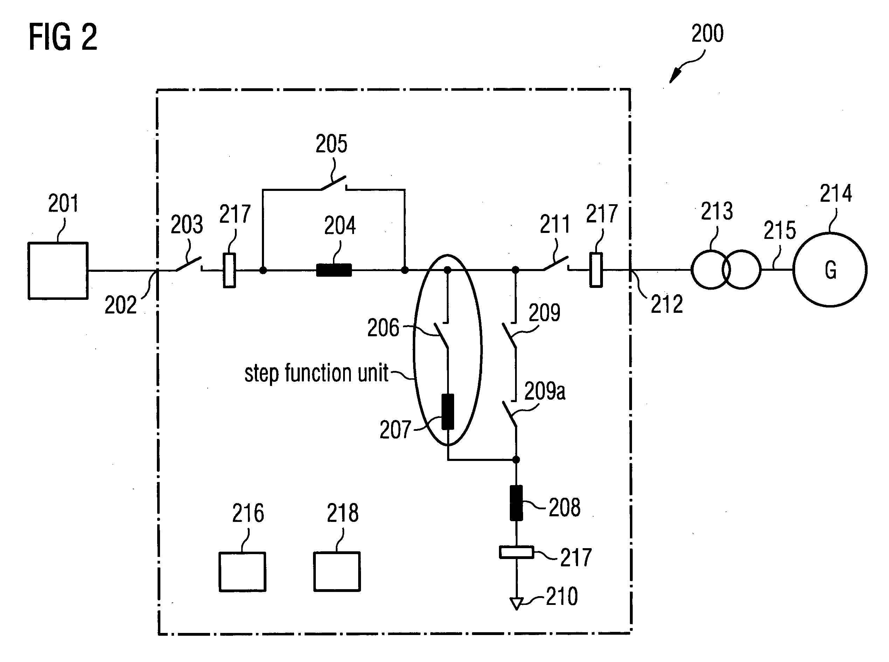

Fig. 1 schematically illustrates an arrangement 100 for testing an electric power generation system according to an embodiment and Fig. 2 schematically illustrates an arrangement 200 for testing an electric power generation system according to another embodiment. Since a number of elements of the arrangement 100 is similar to elements of the arrangement 200 the test arrangements 100 and 200 illustrated in Fig. 1 and Fig. 2, respectively, are described together, wherein the elements comprised in the test arrangement 200 are added in parentheses.

The test arrangement 100 (200) comprises an input terminal 112 (212) for connecting the arrangement 100 (200) to an output terminal 115 (215) of a generating plant or electric power generation system 114 (214). In particular, the input terminal 112 (212) of the arrangement 100 (200) is connected via a transformer 113 (213) to the output terminal 115 (215) of the generating plant, here a wind turbine system. It should be noted that the generating plant transformer 113 (213) is optional. The electric power generation system 114 (214) may comprise one or more output terminals corresponding to one or more electric phases of the electric power signal supplied from the electric power generation system 114 (214), but the additional output terminals are not illustrated in Figs. 1 and 2 in order not to obscure the illustration.

Further, the test arrangement 100 (200) comprises a grid terminal 102 (202) for connecting the arrangement 100 (200) to a utility grid 101 (201).

The test arrangement 100 (200) comprises an optional main breaker 103 (203) to connect or disconnect the test arrangement or test unit 100 (200) to or from the utility grid 101 (201). Further, the test arrangement 100 (200) comprises a variable or fixed series impedance 104 (204) and a bypass main switch 105 (205) connected in parallel to the impedance 104 (204) to bypass the impedance 104 (204). Further, the test arrangement 100 (200) comprises a parallel short-cut switch 106 (206) connected to the input terminal 112 (212). Further, the test arrangement 100 (200) comprises a variable impedance 107 (207) which may selectively be connected (via opening or closing the short-cut switch 106 (206)) to the input terminal 112 (212).

Further, the test arrangement 100 (200) comprises a short-cut variable or fixed impedance 108 (208) which may selectively be connected to the input terminal 112 (212) by closing the short-cut main switch 109 (compare Fig. 1) or by closing the short-cut main switch 209 and the second short-cut main switch 209a (compare Fig. 2). The short-cut variable or fixed impedance 108 (208) is connected to a short-cut reference point 110 (210) which may be changed by switch or manually between phase (in start or delta) and/or to ground. Further, the test arrangement 100 (200) comprises an optional main breaker 111 (211) to disconnect or connect the test arrangement 100 (200) from or to the generating plant or electric power generation system 114 (214).

A difference between the test arrangements 100 and 200 illustrated in Fig. 1 and Fig. 2, respectively, is that while the short-cut variable or fixed impedance 108 is connected via a single short-cut main switch 109 to the input terminal 112, the short-cut variable or fixed impedance 208 is connected via two switches 209 and 209a to the input terminal 212. By providing the two switches 209 and 209a a switching time, in particular a time interval during which an electric connection is established between the input terminal 212 and the impedance 208 is established, can be reduced or may be more accurately controlled, thereby more accurately defining the time interval during which current flows via the input terminal 212 through the impedance 208 towards the reference point or short-cut reference point 210. Thereby, a time course of a voltage applied at the input terminal 212 may more accurately be defined.

The test arrangement 100 (200) further comprises a measurement system 116 comprising a number of measurement sensors 117 for measuring current and/or voltage at a number of locations within the test arrangement 100 (200). The measurement system 116, 117 (216, 217) is further adapted for acquiring measurement data regarding voltage and/or current, storing the measurement data and evaluating or analyzing the measurement data in order to determine, whether the electric power generation system 114 (214) satisfies predetermined criteria regarding a response to the applied stepwise voltage drop at the input terminal 112 (212).

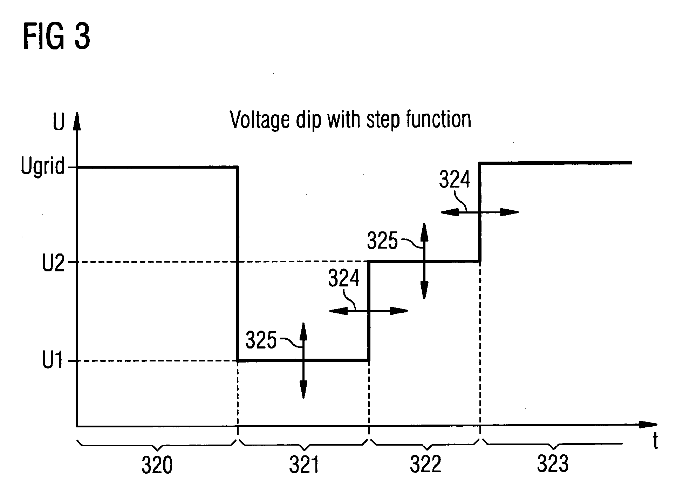

In order to control opening and/or closing of the switches 103 (203), 105 (205), 106 (206), 109 (209), 111 (211) and 209a the test arrangement 100 (200) further comprises a control system 118 providing control signals to the above-mentioned switches (wherein the control lines for supplying the control signals are not indicated in Fig. 1 and Fig. 2). In particular, the control system is adapted to control a shunt coil system comprising the first coil 108 (208), the second coil 107 (207), the switch 106 (206) and the switch 109 (209, 209a) such that the voltage at the input terminal 112 (212) follows the voltage time course illustrated in Fig. 3 comprising the first voltage U1 and the second voltage U2, as is detailed below.

Fig. 3 schematically illustrates a diagram of a time course of a voltage U applied at the input terminal 112 (212) of the arrangement 100 (200) during a method for testing the electric power generation system 114 (214) according to an embodiment. On an abscissa the time t is indicated, while at the ordinate the voltage U applied at the input terminal 112 (212) is illustrated.

As is illustrated in Fig. 3, during a time interval 320 the switches 103 (203), 105 (205) and 111 (211) are closed and the switches 106, 109 (206, 209, 209a) are opened such that the grid voltage Ugrid is applied at the input terminal 112 (212). During a first predetermined time interval 321 the switch 105 (205) is opened and the switch 109 (209 and 209a) is closed resulting in a voltage drop from the voltage Ugrid to the first predetermined voltage U1. During a second predetermined time interval 322 the switch 109 (209, 209a) is opened, while the switch 106 (206) is closed such that the first coil 108 (208) and the second coil 107 (207) are connected in series between the input terminal 112 (212) and the reference node 110 (210). Thereby, the voltage drop is reduced such that the second voltage U2 is applied at the input terminal 112 (212) during the second time interval 322. During the time interval 323 the switch 106, 109 (206, 209, 209a) is opened again and the switch 105 (205) is closed again such that the grid voltage Ugrid is again applied at the input terminal 112 (212).

As indicated by the double arrows 324, the time points at which the voltage at the input terminal changes may be shifted and thus adapted as required. Further, as is indicated by the double arrows 325, also the absolute values of the first voltage U1 and the second voltage U2 may be adapted by appropriately configuring or selecting the impedances of the elements 108 (208) and/or 107 (207). Thereby, a high flexibility of designing and generating a time course of a voltage applied to the input terminal 112 (212) is enabled. In particular, the control system 118 (218) may be configured to control the switches and/or coils or inductors comprised in the test arrangement such that the time course of the voltage as illustrated in Fig. 3 is generated.

In particular, during one or more of the time intervals 320, 321, 322 and 323 the electrical response of the electric power generation system 114 (214) may be measured or acquired or examined or analyzed using the measuring system 116, 117 (216, 217). Thereby, in particular a wind turbine may be tested or examined close to real life electrical situations, such as voltage drops occurring at a utility grid. Thereby, more information how the wind turbine reacts in this case of a grid behavior may be obtained.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. Arrangement for testing an electric power generation system connected to a utility grid operating at a grid voltage, the arrangement comprising:
• a input terminal (112, 212) for connecting the arrangement to an output terminal (115, 215) of the power generation system (114, 214);
• a grid terminal (102, 202) for connecting the arrangement to the utility grid (101, 201);
• a series coil (104, 204) connected between the input terminal and the grid terminal;
• a reference node (110, 210) for connecting to a reference electric potential; and
• a shunt coil system (106,107,108,109; 206,207,208,209,209a) having a variable impedance, wherein the shunt coil system is connected between the input terminal and the reference node and the variable impedance is adjustable such that a voltage (U) at the input terminal (112, 212) selectively amounts to a predetermined first voltage (U1) or to a predetermined second voltage (U2) different form the first voltage, wherein the first voltage and the second voltage are both lower than the grid voltage.

2. Arrangement according to claim 1, wherein the shunt coil system is adapted
to adopt a first impedance, resulting in the first voltage (U1) at the input terminal being between 0% and 20%, in particular between 0% and 10%, of the grid voltage.

3. Arrangement according to claim 2, wherein the shunt coil system is adapted
to adopt a second impedance, resulting in the second voltage (U2) at the input terminal being between 50% and 95%, in particular being between 80% and 90%, of the grid voltage.

4. Arrangement according to claim 2 or 3, wherein
the first impedance is adopted during a first time interval (321) which amounts in particular to between 0.1 s and 2 s, further in particular to between 0.5 s and 1 s.

5. Arrangement according to claim 3 or 4, wherein the second impedance is adopted during a second time interval (322) different from the first time interval, wherein the second time interval amounts in particular to between 0.5 s and 10 s, further in particular to between 1 s and 5 s.

6. Arrangement according to one of claims 2 to 5, wherein the shunt coil system comprises a first coil (108, 208) and a second coil (107, 207) that are connectable in series between the input terminal and the reference node.

7. Arrangement according to claim 6, wherein
the first impedance is adopted, if exclusively the first coil but not the second coil is connected between the input terminal and the reference point and
the second impedance is adopted, if the first coil and the second coil are connected in series between the input terminal and the reference point.

8. Arrangement according to claim 6 or 7, wherein the shunt coil system comprises a first switch (109), in particular two first switches (209,209a), connected in series with the first coil.

9. Arrangement according to one of claims 6 to 8, wherein the shunt coil system comprises a second switch (106, 206) connected in series with the second coil.

10. Arrangement according to one of the preceding claims, further comprising
• a measurement system (116,117; 216,217) adapted for measuring a current flow at the input terminal, at a point between the shunt coil system and the reference node and/or at the grid terminal.

11. Arrangement according to claim 10, wherein the measurement system is further adapted for measuring a voltage between a fixed potential node and the input terminal and/or a point between the shunt coil system and the reference node and/or the grid terminal.

12. Arrangement according to one of the preceding claims, further comprising:
• a control system (118, 218) for controlling the shunt coil system such that a voltage at the input terminal follows a predetermined voltage time course comprising the first voltage succeeded by the second voltage.

13. Arrangement according to one of the preceding claims, wherein the electric power generation system is a wind turbine system.

14. Method for testing an electric power generation system connected to a utility grid operating at a grid voltage, the method comprising:
• connecting an arrangement, via an input terminal, to an output terminal of the power generation system;
• connecting the arrangement, via a grid terminal, to the utility grid, wherein a series coil is connected between the input terminal and the grid terminal; and
• varying an impedance of a shunt coil system connected between the input terminal and a reference node such that a voltage at the input terminal selectively amounts to a predetermined first voltage or to a predetermined second voltage different form the first voltage, wherein the first voltage and the second voltage are both lower than the grid voltage.

15. Method according to claim 14, wherein the electric power generation system is a wind turbine system.

## Patentansprüche

1. Anordnung zum Prüfen eines Stromerzeugungssystems, das mit einem Versorgungsnetz verbunden ist, das bei einer Netzspannung betrieben wird, wobei die Anordnung umfasst:
• eine Eingangsklemme (112, 212) zum Verbinden der Anordnung mit einer Ausgangsklemme (115, 215) des Stromerzeugungssystems (114, 214);
• eine Netzanschlussklemme (102, 202) zum Verbinden der Anordnung mit dem Versorgungsnetz (101, 201);
• eine Reihenschlussspule (104, 204), die zwischen die Eingangsklemme und die Netzanschlussklemme geschaltet ist;
• einen Referenzknoten (110, 210) zum Verbinden mit einem elektrischen Referenzpotential; und
• ein Nebenschlussspulensystem (106, 107, 108, 109; 206, 207, 208, 209, 209a) mit einer variablen Impedanz, wobei das Nebenschlussspulensystem zwischen die Eingangsklemme und den Referenzknoten geschaltet ist und die variable Impedanz so einstellbar ist, dass eine Spannung (U) an der Eingangsklemme (112, 212) selektiv gleich einer vorbestimmten ersten Spannung (U1) oder gleich einer von der ersten Spannung verschiedenen vorbestimmten zweiten Spannung (U2) ist, wobei die erste Spannung und die zweite Spannung beide niedriger als die Netzspannung sind.

2. Anordnung nach Anspruch 1, wobei das Nebenschlussspulensystem dazu eingerichtet ist, einen ersten Impedanzwert anzunehmen, welcher zur Folge hat, dass die erste Spannung (U1) an der Eingangsklemme zwischen 0 % und 20 %, insbesondere zwischen 0 % und 10 %, der Netzspannung beträgt.

3. Anordnung nach Anspruch 2, wobei das Nebenschlussspulensystem dazu eingerichtet ist, einen zweiten Impedanzwert anzunehmen, welcher zur Folge hat, dass die zweite Spannung (U2) an der Eingangsklemme zwischen 50 % und 95 %, insbesondere zwischen 80 % und 90 %, der Netzspannung beträgt.

4. Anordnung nach Anspruch 2 oder 3, wobei der erste Impedanzwert während eines ersten Zeitintervalls (321) angenommen wird, welches insbesondere zwischen 0,1 s und 2 s, ferner insbesondere zwischen 0,5 s und 1 s beträgt.

5. Anordnung nach Anspruch 3 oder 4, wobei der zweite Impedanzwert während eines von dem ersten Zeitintervall verschiedenen zweiten Zeitintervalls (322) angenommen wird, wobei das zweite zeitintervall insbesondere zwischen 0,5 s und 10 s, ferner insbesondere zwischen 1 s und 5 s beträgt.

6. Anordnung nach einem der Ansprüche 2 bis 5, wobei das Nebenschlussspulensystem eine erste Spule (108, 208) und eine zweite Spule (107, 207) umfasst, welche zwischen die Eingangsklemme und den Referenzknoten in Reihe schaltbar sind.

7. Anordnung nach Anspruch 6, wobei
der erste Impedanzwert angenommen wird, falls ausschließlich die erste Spule, nicht jedoch die zweite Spule zwischen die Eingangsklemme und den Referenzpunkt geschaltet ist, und
der zweite Impedanzwert angenommen wird, falls die erste Spule und die zweite Spule zwischen die Eingangsklemme und den Referenzpunkt in Reihe geschaltet sind.

8. Anordnung nach Anspruch 6 oder 7, wobei das Nebenschlussspulensystem einen ersten Schalter (109), insbesondere zwei erste Schalter (209, 209a), umfasst, die mit der ersten Spule in Reihe geschaltet sind.

9. Anordnung nach einem der Ansprüche 6 bis 8, wobei das Nebenschlussspulensystem einen zweiten Schalter (106, 206) umfasst, der mit der zweiten Spule in Reihe geschaltet ist.

10. Anordnung nach einem der vorhergehenden Ansprüche, welche ferner umfasst:
• ein Messsystem (116, 117; 216, 217), das für das Messen eines Stromflusses an der Eingangsklemme, an einem Punkt zwischen dem Nebenschlussspulensystem und dem Referenzknoten und/oder an der Netzanschlussklemme geeignet ist.

11. Anordnung nach Anspruch 10, wobei das Messsystem ferner für das Messen einer Spannung zwischen einem Knoten mit festem Potential und der Eingangsklemme und/oder einem Punkt zwischen dem Nebenschlussspulensystem und dem Referenzknoten und/oder der Netzanschlussklemme geeignet ist.

12. Anordnung nach einem der vorhergehenden Ansprüche, welche ferner umfasst:
• ein Steuerungssystem (118, 218) zum Steuern des Nebenschlussspulensystems, derart, dass eine Spannung an der Eingangsklemme einem vorbestimmten zeitlichen Spannungsverlauf folgt, welcher die erste Spannung umfasst, auf welche die zweite Spannung folgt.

13. Anordnung nach einem der vorhergehenden Ansprüche, wobei das Stromerzeugungssystem ein Windturbinensystem ist.

14. Verfahren zum Prüfen eines Stromerzeugungssystems, das mit einem Versorgungsnetz verbunden ist, das bei einer Netzspannung betrieben wird, wobei das Verfahren umfasst:
• Verbinden einer Anordnung über eine Eingangsklemme mit einer Ausgangsklemme des Stromerzeugungssystems;
• Verbinden der Anordnung über eine Netzanschlussklemme mit dem Versorgungsnetz, wobei eine Reihenschlussspule zwischen die Eingangsklemme und die Netzanschlussklemme geschaltet ist; und
• Variieren einer Impedanz eines Nebenschlussspulensystems, das zwischen die Eingangsklemme und einen Referenzknoten geschaltet ist, so dass eine Spannung an der Eingangsklemme selektiv gleich einer vorbestimmten ersten Spannung oder gleich einer von der ersten Spannung verschiedenen vorbestimmten zweiten Spannung ist, wobei die erste Spannung und die zweite Spannung beide niedriger als die Netzspannung sind.

15. Verfahren nach Anspruch 14, wobei das Stromerzeugungssystem ein Windturbinensystem ist.

## Revendications

1. Agencement pour tester un système de production d'énergie électrique raccordé à un réseau de distribution d'énergie fonctionnant sous une tension de réseau, l'agencement comprenant :
- une borne d'entrée (112, 212) pour raccorder l'agencement à une borne de sortie (115, 215) du système de production d'énergie (114, 214) ;
- une borne de réseau (102, 202) pour raccorder l'agencement au réseau de distribution d'énergie (101, 201) ;
- une bobine en série (104, 204) branchée entre la borne d'entrée et la borne de réseau ;
- un noeud de référence (110, 210) pour le raccordement à une tension électrique de référence ; et
- un système de bobine shunt (106,107,108,109; 206,207,208,209,209a) ayant une impédance variable, dans lequel le système de bobine shunt est branché entre la borne d'entrée et le noeud de référence et l'impédance variable est réglable de telle sorte que la tension (U) à la borne d'entrée (112, 212) s'élève, de façon sélective, à une première tension prédéterminée (U1) ou à une seconde tension prédéterminée (U2) différente de la première tension, la première tension et la seconde tension étant toutes deux inférieures à la tension de réseau.

2. Agencement selon la revendication 1, dans lequel le système de bobine shunt est adapté pour adopter une première impédance, avec pour résultat que la première tension (U1) à la borne d'entrée représente entre 0% et 20%, notamment entre 0% et 10%, de la tension de réseau.

3. Agencement selon la revendication 2, dans lequel le système de bobine shunt est adapté pour adopter une seconde impédance, avec pour résultat que la seconde tension (U2) à la borne d'entrée représente entre 50% et 95%, notamment entre 80% et 90%, de la tension de réseau.

4. Agencement selon la revendication 2 ou 3, dans lequel la première impédance est adoptée pendant un premier intervalle de temps (321) qui dure notamment entre 0,1 s et 2 s, et plus précisément entre 0,5 s et 1 s.

5. Agencement selon la revendication 3 ou 4, dans lequel la seconde impédance est adoptée pendant un second intervalle de temps (322) différent du premier intervalle de temps, le second intervalle de temps durant notamment entre 0,5 s et 10 s, et plus précisément entre 1 s et 5 S.

6. Agencement selon l'une quelconque des revendications 2 à 5, dans lequel le système de bobine shunt comprend une première bobine (108, 208) et une seconde bobine (107, 207) qui peuvent être branchées en série entre la borne d'entrée et le noeud de référence.

7. Agencement selon la revendication 6, dans lequel la première impédance est adoptée si seule la première bobine, mais pas la seconde bobine, est branchée entre la borne d'entrée et le point de référence et
la seconde impédance est adoptée si la première bobine et la seconde bobine sont branchées en série entre la borne d'entrée et le point de référence.

8. Agencement selon la revendication 6 ou 7, dans lequel le système de bobine shunt comprend un premier commutateur (109), notamment deux premiers commutateurs (209, 209a), branché(s) en série avec la première bobine.

9. Agencement selon l'une quelconque des revendications 6 à 8, dans lequel le système de bobine shunt comprend un second commutateur (106, 206) branché en série avec la seconde bobine.

10. Agencement selon l'une quelconque des revendications précédentes, comprenant, en outre :
- un système de mesure (116,117; 216,217) adapté pour mesurer le passage d'un courant à la borne d'entrée en un point entre le système de bobine shunt et le noeud de référence et/ou à la borne de réseau.

11. Agencement selon la revendication 10, dans lequel le système de mesure est adapté, en outre, pour mesurer une tension entre un noeud de tension fixe et la borne d'entrée et/ou un point entre le système de bobine shunt et le noeud de référence et/ou la borne de réseau.

12. Agencement selon l'une quelconque des revendications précédentes, comprenant, en outre :
- un système de commande (118, 218) pour commander le système de bobine shunt de telle sorte qu'une tension à la borne d'entrée suive un ordre prédéterminé des tensions dans le temps comprenant la première tension suivie de la seconde tension.

13. Agencement selon l'une quelconque des revendications précédentes, dans lequel le système de production d'énergie électrique est un système d'éolienne.

14. Procédé pour tester un système de production d'énergie électrique raccordé à un réseau de distribution d'énergie fonctionnant sous une tension de réseau, le procédé comprenant :
- le raccordement d'un agencement, par le biais d'une borne d'entrée, à une borne de sortie du système de production d'énergie ;
- le raccordement de l'agencement, par le biais d'une borne de réseau, au réseau de distribution d'énergie, une bobine en série étant branchée entre la borne d'entrée et la borne de réseau ; et
- la variation de l'impédance d'un système de bobine shunt branché entre la borne d'entrée et un noeud de référence de telle sorte que la tension à la borne d'entrée s'élève, de façon sélective, à une première tension prédéterminée ou à une seconde tension prédéterminée différente de la première tension, la première tension et la seconde tension étant toutes deux inférieures à la tension de réseau.

15. Procédé selon la revendication 14, dans lequel le système de production d'énergie électrique est un système d'éolienne.
